Europäisches Patentamt

European Patent Office

Office européen des brevets

(11) Numéro de publication : **0 382 585 B1**

# (12) FASCICULE DE BREVET EUROPEEN

(45) Date de publication du fascicule du brevet :
**27.10.93 Bulletin 93/43**

(51) Int. Cl.$^5$ : **C22C 19/05,** C30B 11/00,
C30B 29/52

(21) Numéro de dépôt : **90400062.7**

(22) Date de dépôt : **09.01.90**

(54) **Superalliage à base de nickel pour aubes de turbines industrielles.**

Le dossier contient des informations techniques présentées postérieurement au dépôt de la demande et ne figurant pas dans le présent fascicule.

(30) Priorité : **10.02.89 FR 8901774**

(43) Date de publication de la demande :
**16.08.90 Bulletin 90/33**

(45) Mention de la délivrance du brevet :
**27.10.93 Bulletin 93/43**

(84) Etats contractants désignés :
**CH DE GB IT LI NL SE**

(56) Documents cités :
**EP-A- 0 076 360**
**FR-A- 2 519 033**
**GB-A- 1 166 686**
**GB-A- 2 073 774**
**US-A- 4 388 124**
**Handbook of Superalloys, Metals and Ceramics Information Center, Battelle, 1979, p. 193**

(73) Titulaire : **OFFICE NATIONAL D'ETUDES ET DE RECHERCHES AEROSPATIALES(O.N.E.R.A.)**
**29, avenue de la Division Leclerc**
**F-92322 Châtillon Cédex (FR)**

(72) Inventeur : **Khan, Tasadduq**
**18, Parc de Diane**
**F-78350 Jouy-en-Josas (FR)**
Inventeur : **Caron, Pierre**
**7, avenue de Champagne, La Treille**
**F-91940 Les Ulis (FR)**
Inventeur : **Raffestin, Jean-Louis**
**10, Résidence du Bois du Roi**
**F-91940 Les Ulis (FR)**
Inventeur : **Naveos, Serge**
**64, avenue Ramond Crosland**
**F-92350 Plessis-Robinson (FR)**

(74) Mandataire : **Plaçais, Jean-Yves et al**
**Cabinet Netter, 40, rue Vignon**
**F-75009 Paris (FR)**

## Description

L'invention concerne les superalliages à base de nickel pour turbines à gaz.

Pour obtenir d'excellents rendements des turbines à gaz, il est nécessaire de les faire fonctionner à des températures élevées, ce qui exige la mise au point de matériaux ayant une grande résistance au fluage à ces températures élevées. Les matériaux les plus performants à cet égard sont des superalliages à base de nickel élaborés par solidification dirigée et ayant une structure soit du type dit "monocristallin", soit du type "à grains colonnaires". Les pièces en superalliages dits monocristallins comportent en réalité une matrice gamma monocristalline dans laquelle sont dispersées des particules gamma prime présentant avec la matrice une cohérence telle que l'ensemble possède sensiblement les propriétés d'un cristal unique.

Les superalliages à grains colonnaires sont formés de grains juxtaposés allongés dans la direction de solidification et ayant chacun une structure semblable à celle d'un superalliage dit monocristallin.

Ces alliages connus, élaborés par solidification dirigée, sont utilisés pour les aubes de turbines aéronautiques. Cependant, ils ne conviennent pas pour les turbines industrielles (ou terrestres), leur tenue à la corrosion dans le temps étant insuffisante compte tenu des durées de fonctionnement très longues de ces turbines, généralement comprises entre 50 000 et 100 000 heures. L'alliage le plus couramment utilisé actuellement pour fabriquer les aubes de turbines industrielles est celui dénommé IN 738 (United States Alloy Designation). Il possède une excellente résistance à la corrosion et une bonne tenue en fluage. Toutefois, sur ce dernier point, il est nettement en deçà des superalliages monocristallins ou à grains colonnaires évoqués plus haut. Des tentatives pour appliquer la technique de la solidification dirigée à des alliages du type IN 738 n'ont donné aucun résultat.

Le but de l'invention est de fournir un superalliage à base de nickel présentant, aux températures élevées, à la fois une tenue à la corrosion au moins équivalente à celle de l'alliage IN 738, et une résistance au fluage sensiblement améliorée par rapport à celui-ci. Un tel superalliage convient particulièrement bien à l'élaboration d'aubes de turbines à gaz industrielles, ainsi qu'à celle d'aubes des seconds étages de turbines à gaz aéronautiques.

Ce but est atteint, selon l'invention, par un superalliage apte à la solidification dirigée dont la composition pondérale est la suivante :

Co : 0 à 5%
Cr : 13 à 16%
W : 0 à 2%
Mo : 2 à 3,5%
Al : 3,5 à 4%
Ti : 3,5%
Ta : 3,5 à 4%
Hf : 0 à 1%
C : 0 à 600 ppm
Zr : 0 à 150 ppm
B : 0 à 150 ppm
Ni : complément à 100%

GB-A-2 073 774 divulgue un alliage apte à la solidification monocristalline dont les pourcentages en poids des constituants sont définis comme suit :

Cr : 10 à 16
Co : 4 à 16
Mo : 2 à 4
W : 0 à 2
Ta : 2 à 8
Mo + W/2 + Ta/3 : 4 à 6
Al : 4 à 6
Ti : 1 à 4
Al + Ti/2 : 5 à 7
C : 0,015 à 0,05
B : 0 à 0,01
Zr : 0 à 0,01
Ni + impuretés accidentelles : complément à 100.

Dans le cadre du domaine de composition ci-dessus, on obtient un alliage apte à la solidification monocristalline lorsque les teneurs en Co, Hf, C, Zr et B sont pratiquement nulles.

Au contraire, l'alliage est plus particulièrement apte à la solidification en grains colonnaires lorsque sa composition pondérale est la suivante :

Co : 0 à 5%
Cr : 16%
Mo : 3%
Al : 3,5%
Ti : 3,5%
Ta : 3,5%
Hf : 1%
C : 600 ppm
Zr : 150 ppm
B : 150 ppm
Ni : complément à 100%

L'invention vise également une aube de turbine à gaz réalisée en un superalliage tel que défini ci-dessus.

D'autres caractéristiques et avantages de l'invention ressortiront de la description détaillée ci-après, et des dessins annexés, dans lesquels :

- la figure 1 est un diagramme représentant les variations de poids d'un échantillon d'alliage selon l'invention et d'un échantillon d'alliage IN-738 au cours d'un essai de corrosion à chaud; et
- la figure 2 est un diagramme montrant l'évolution de la résistance au fluage de différents alliages en fonction de la température.

On a préparé cinq superalliages selon l'invention, dont les compositions approximatives sont données dans le tableau 1. Les concentrations pondérales sont indiquées en ppm pour les éléments C, Zr et B et en % pour les autres éléments, le complément à 100% étant constitué par le nickel.

Ces alliages ont subi un traitement thermique de mise en solution et de reprécipitation de la phase gamma prime tel que décrit dans FR-A-2 503 188, les températures et les durées de traitement étant choisies à chaque fois de façon à optimiser les propriétés de l'alliage, ainsi que l'homme de métier est en mesure de le faire grâce à son expérience.

Ainsi, l'alliage référencé SC 16 a été chauffé à 1250°C pendant une heure puis refroidi à l'air pour mettre en solution la phase gamma prime. L'alliage SC 16-2 a été chauffé à 1245°C pendant une heure, puis refroidi à l'air. L'alliage SC 13-0 a été chauffé à 1260°C pendant deux heures, puis sa température a été élevée en une heure à 1275°C et maintenue à cette dernière valeur pendant trois heures, après quoi l'alliage a été refroidi à l'air. Les alliages DS 16-1 et DS 16-2 ont été chauffés à 1150°C pendant trois heures, puis leur température a été élevée en une heure à 1200°C et maintenue à cette dernière valeur pendant deux heures, après quoi l'alliage a été refroidi à l'air puis de nouveau chauffé à 1220°C pendant trois heures avant d'être une nouvelle fois refroidi à l'air.

Pour tous ces alliages, la reprécipitation de la phase gamma prime a été effectuée en chauffant à 1100°C pendant quatre heures, puis en refroidissant à l'air avant de réchauffer à 850°C pendant 24 heures et de refroidir de nouveau à l'air. On a obtenu ainsi une répartition régulière des particules gamma prime au sein de l'alliage, ces particules ayant une taille comprise entre 0,2 et 0,8 micron.

Le tableau 1 donne également, pour chaque alliage, la masse volumique d en g/cm³, la fraction volumique de la phase gamma prime (%γ') et le paramètre Nv (nombre de trous électroniques), défini de façon connue suivant les concentrations atomiques des éléments dans la matrice de l'alliage.

Comme il est bien connu dans la technique, lorsque le paramètre Nv est supérieur à 2,45, l'alliage risque d'être instable, c'est-à-dire de donner lieu, au cours d'une utilisation prolongée, à la précipitation de phases parasites telles que les phases sigma et mu. Les alliages selon l'invention ont tous une valeur de Nv inférieure à 2,45.

Le tableau 2, analogue au tableau 1, est relatif à des alliages proches par leur composition des alliages selon l'invention, mais qui s'en écartent néanmoins.

L'alliage SC 13-2 a subi un traitement de mise en solution de la phase gamma prime semblable à celui de l'alliage SC 13-0, à ceci près que le second palier de températures a été porté à 1280°C. L'alliage SC 13-3 a été chauffé à 1250°C pendant deux heures, puis sa température a été élevée en une heure à 1270°C et maintenue à cette dernière valeur pendant trois heures, après quoi l'alliage a été refroidi à l'air. Ces deux alliages ont ensuite subi un traitement de précipitation semblable à celui des alliages du tableau 1.

On voit sur le tableau 2 que la fraction volumique de la phase gamma prime est plus élevée que pour les alliages du tableau 1. Il en résulte des concentrations accrues de Cr, Mo et W dans la matrice, c'est-à-dire dans la phase gamma. Le paramètre Nv est ainsi supérieur à 2,45, et ces alliages sont instables.

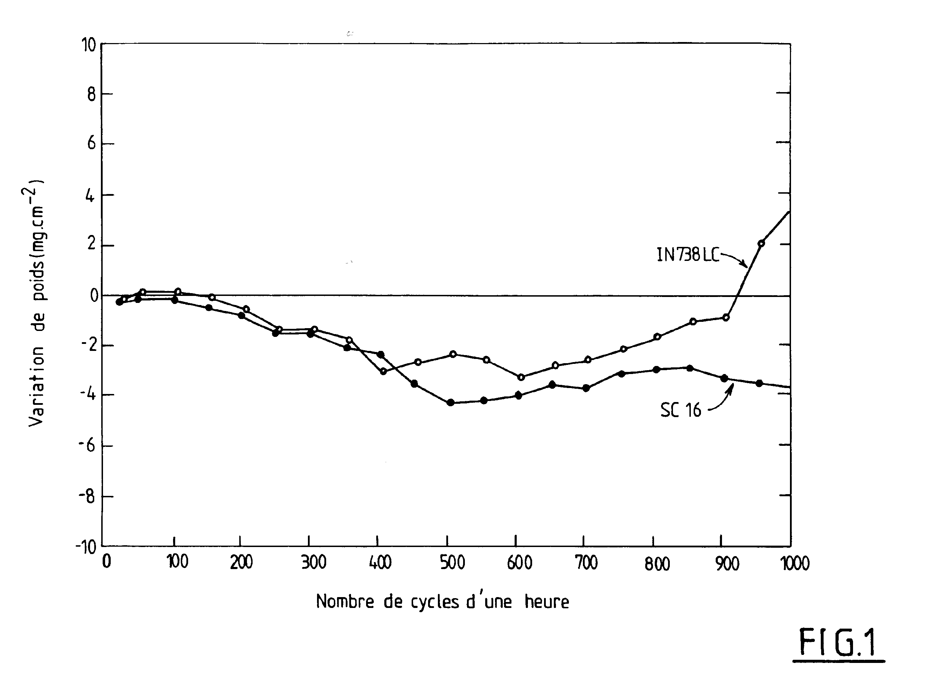

Les courbes de la figure 1, qui concerne les essais de résistance à la corrosion, représentent la variation de poids d'un échantillon d'alliage IN 738 et d'un échantillon d'alliage SC 16 respectivement en fonction du nombre de cycles thermiques subis, chaque cycle comportant un maintien d'une heure à 850°C dans l'air sous pression atmosphérique, les échantillons étant contaminés avec $Na_2SO_4$ (0,5 mg.cm$^{-2}$ renouvelé toutes les cinquante heures) et étant refroidis à température ambiante à chaque cycle. Le comportement des deux échantillons au cours des neuf cents premiers cycles n'est pas significativement différent : on observe dans les deux cas des pertes de poids inférieures à 5 milligrammes par centimètre carré, qui ne révèlent pas une corrosion appréciable. Entre 900 et 1000 cycles, ce comportement ne change pas pour l'alliage SC 16, tandis que pour l'alliage IN 738 s'amorce une brusque augmentation de poids. L'alliage SC 16 selon l'invention apparaît donc au moins équivalent à l'alliage IN 738 en ce qui concerne la tenue à la corrosion à chaud, contrairement à tous les alliages monocristallins connus précédemment.

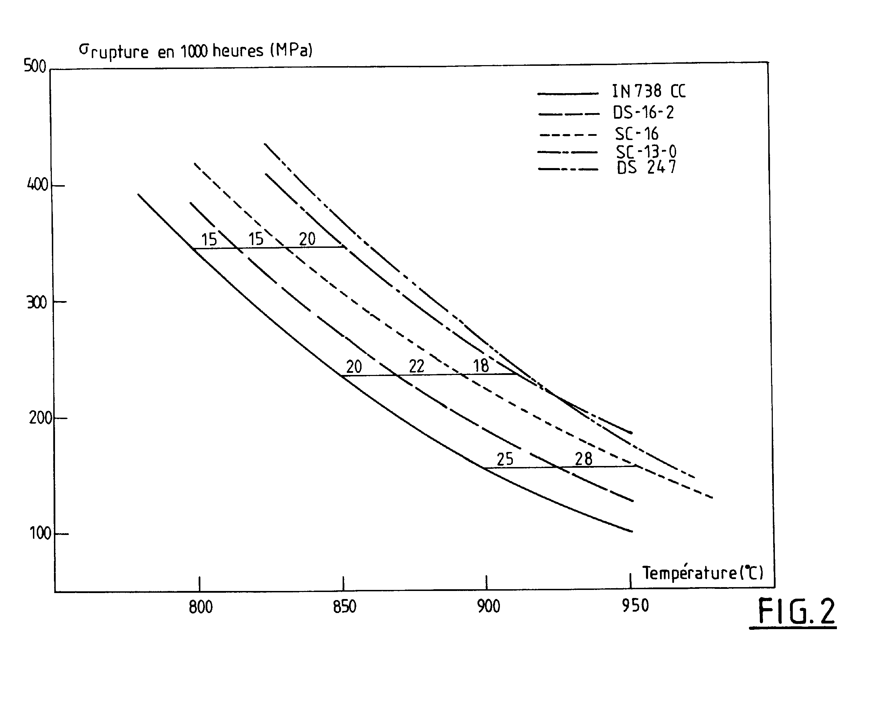

Les tableaux 3 à 6 donnent des résultats d'essais de fluage à chaud pour les alliages SC 16, SC 13-0, SC 13-2 et SC 13-3 respectivement. Les courbes de la figure 2 représentent la variation, en fonction de la température, de la contrainte sigma entraînant une rupture en mille heures pour les alliages SC 16, SC 13-0 et DS 16-2, pour l'alliage de référence IN 738 et pour un autre alliage connu appelé DS-MAR-M 247, utilisé couramment pour les turbines aéronautiques.

On voit que la courbe relative à ce dernier alliage est décalée vers la droite d'environ 60°C par rapport à celle de l'alliage IN 738, ce qui traduit un gain en température de 60°C. Cependant, l'alliage DS 247 n'est pas utilisable dans les turbines industrielles en raison de sa résistance à la corrosion insuffisante.

L'alliage SC 13-0 selon l'invention a des performances en fluage très voisines de celles de l'alliage DS 247. L'alliage SC 16 apporte par rapport à l'alliage IN 738 un gain en température allant de 30°C environ (830°C au lieu de 800) à 50°C environ (950 au lieu de 900). Le gain apporté par l'alliage DS 16-2, non conforme à l'invention, est sensiblement inférieur.

La comparaison entre les tableaux 3 et 5 montre que, du fait de l'instabilité de l'alliage SC 13-2, la ductilité devient plus faible (1,6% à 850°C sous 350 MPa au lieu de 17,8%).

## Tableau 1

| Réf | Co | Cr | W | Mo | Al | Ti | Ta | Hf | C | Zr | B | d | %γ' | Nv |
|---|---|---|---|---|---|---|---|---|---|---|---|---|---|---|
| SC 16 | − | 16 | − | 3 | 3,5 | 3,5 | 3,5 | − | − | − | − | 8,21 | 48,1 | 2,35 |
| SC 16-2 | − | 16 | 2 | 2 | 3,5 | 3,5 | 3,5 | − | − | − | − | 8,30 | 50,0 | 2,38 |
| SC 13-0 | − | 13 | − | 3,5 | 4 | 3,5 | 4 | − | − | − | − | 8,22 | 54,7 | 2,30 |
| DS 16-1 | − | 16 | − | 3 | 3,5 | 3,5 | 3,5 | 1 | 600 | 150 | 150 | 8,27 | 50,3 | 2,36 |
| DS 16-2 | 5 | 16 | − | 3 | 3,5 | 3,5 | 3,5 | 1 | 600 | 150 | 150 | 8,25 | 50,4 | 2,44 |

## Tableau 2

| Réf | Co | Cr | W | Mo | Al | Ti | Ta | Hf | C | Zr | B | d | %γ' | Nv |
|---|---|---|---|---|---|---|---|---|---|---|---|---|---|---|
| SC 13-2 | 5 | 13 | 2 | 3 | 4,5 | 3 | 4 | − | − | − | − | 8,29 | 59,7 | 2,54 |
| SC 13-3 | 5 | 13 | 3 | 3 | 5,5 | 3 | 3,5 | − | − | − | − | 8,13 | 75,8 | 3,12 |

EP 0 382 585 B1

Tableau 3

Alliage SC-16

| Température (°C) | Contrainte (MPa) | Temps pour une déformation de 1% (h) | Temps à rupture (h) | Allongement (%) |
|---|---|---|---|---|
| 850 | 400 | 22 | 138 | 18,6 |
| | 350 | 85 | 402 | 17,8 |
| | 300 | 268 | 1060 | 11,0 |
| 950 | 200 | 61 | 287 | 17,9 |
| | 175 | 193 | 626 | 19,5 |
| | 120 | 4000 | 5354 | 11,5 |
| 1050 | 100 | 69 | 130 | 17,2 |

Tableau 4

Alliage SC 13-0

| Température (°C) | Contrainte (MPa) | Temps pour une déformation de 1% (h) | Temps à rupture (h) | Allongement (%) |
|---|---|---|---|---|
| 850 | 400 | 97 | 368 | 15,9 |
| | 300 | 1640 | >2088 | >1,3 |
| 950 | 200 | 152 | 628 | 14,4 |
| | 175 | 790 | 1508 | 11,0 |

Tableau 5

Alliage SC 13-2

| Température (°C) | Contrainte (MPa) | Temps pour une déformation de 1% (h) | Temps à rupture (h) | Allongement (%) |
|---|---|---|---|---|
| 850 | 400 | 190 | 419 | 13,5 |
| | 350 | 422 | 452 | 1,6 |
| | 300 | 612 | 879 | 6,5 |

Tableau 6

Alliage SC 13-3

| Température (°C) | Contrainte (MPa) | Temps pour une déformation de 1% (h) | Temps à rupture (h) | Allongement (%) |
|---|---|---|---|---|
| 950 | 175 | 88 | 224 | 12,0 |

**Revendications**

1. Superalliage à base de nickel apte à la solidification dirigée, notamment de pièces de turbines à gaz industrielles, caractérisé en ce que sa composition pondérale est la suivante :

   Co : 0 à 5%
   Cr : 13 à 16%
   W : 0 à 2%
   Mo : 2 à 3,5%
   Al : 3,5 à 4%
   Ti : 3,5%
   Ta : 3,5 à 4%

7

Hf      : 0 à 1%
C        : 0 à 600 ppm
Zr      : 0 à 150 ppm
B        : 0 à 150 ppm
Ni      : complément à 100%

2. Superalliage selon la revendication 1, caractérisé en ce qu'il est apte à la solidification monocristalline et en ce qu'il est pratiquement exempt des éléments suivants : Co, Hf, C, Zr et B.

3. Superalliage selon la revendication 2, caractérisé en ce que sa composition pondérale est la suivante :
Cr      : 16%
Mo    : 3%
Al      : 3,5%
Ti      : 3,5%
Ta     : 3,5%
Ni      : complément à 100%

4. Superalliage selon la revendication 2, caractérisé en ce que sa composition pondérale est la suivante :
Cr      : 16%
W       : 2%
Mo    : 2%
Al      : 3,5%
Ti      : 3,5%
Ta     : 3,5%
Ni      : complément à 100%

5. Superalliage selon la revendication 2, caractérisé en ce que sa composition pondérale est la suivante :
Cr      : 13%
Mo    : 3,5%
Al      : 4%
Ti      : 3,5%
Ta     : 4%
Ni      : complément à 100%

6. Superalliage selon la revendication 1, caractérisé en ce qu'il est apte à la solidification en grains colonnaires et en ce que sa composition pondérale est la suivante :
Co     : 0 à 5%
Cr      : 16%
Mo    : 3%
Al      : 3,5%
Ti      : 3,5%
Ta     : 3,5%
Hf      : 1%
C        : 600 ppm
Zr      : 150 ppm
B        : 150 ppm
Ni      : complément à 100%

7. Superalliage selon la revendication 6, caractérisé en ce qu'il est pratiquement exempt de Co.

8. Superalliage selon la revendication 6, caractérisé en ce qu'il contient environ 5% de Co.

9. Aube de turbine à gaz réalisée en un superalliage selon l'une des revendications précédentes.

**Patentansprüche**

1. Superlegierung auf Nickelbasis für die gelenkte Verfestigung insbesondere für industrielle Turbinenteile, <u>dadurch gekennzeichnet</u>, daß ihre Gewichtszusammensetzung wie folgt lautet:

Co : 0 bis 5%
Cr : 13 bis 16%
W : 0 bis 2%
Mo : 2 bis 3,5%
Al : 3,5 bis 4%
Ti : 3,5%
Ta : 3,5 bis 4%
Hf : 0 bis 1%
C : 0 bis 600 ppm
Zr : 0 bis 150 ppm
B : 0 bis 150 ppm
Ni : Komplement zu 100%

2. Superlegierung nach Anspruch 1, dadurch gekennzeichnet, daß sich diese für die monokristalline Verfestigung eignet und diese praktisch frei von folgenden Elementen ist: Co, Hf, C, Zr, und B.

3. Superlegierung nach Anspruch 2, dadurch gekennzeichnet, daß ihre Gewichtszusammensetzung wie folgt lautet:
Cr : 16%
Mo : 3%
Al : 3,5%
Ti : 3,5%
Ta : 3,5%
Ni : Komplement zu 100%

4. Superlegierung nach Anspruch 2, dadurch gekennzeichnet, daß ihre Gewichtszusammensetzung wie folgt lautet:
Cr : 16%
W : 2%
Mo : 2%
Al : 3,5%
Ti : 3,5%
Ta : 3,5%
Ni : Komplement zu 100%

5. Superlegierung nach Anspruch 2, dadurch gekennzeichnet, daß ihre Gewichtszusammensetzung wie folgt lautet:
Cr : 13%
Mo : 3,5%
Al : 4%
Ti : 3,5%
Ta : 4%
Ni : Komplement zu 100%

6. Superlegierung nach Anspruch 1, dadurch gekennzeichnet, daß sie sich für die Säulenkorn-Verfestigung eignet und ihre Gewichtszusammensetzung wie folgt lautet:
Co : 0 bis 5%
Cr : 16%
Mo : 3%
Al : 3,5%
Ti : 3,5%
Ta : 3,5%
Hf : 1%
C : 600 ppm
Zr : 150 ppm
B : 150 ppm
Ni : Komplement zu 100%

7. Superlegierung nach Anspruch 6, dadurch gekennzeichnet, daß sie praktisch frei von Co ist.

8. Superlegierung nach Anspruch 6, dadurch gekennzeichnet, daß sie etwa 5% Co enthält.

9. Gasturbinenschaufel aus einer Superlegierung entsprechend einem der vorgenannten Ansprüche.


**Claims**

1. Nickel-based superalloy suitable for directed solidification, especially of industrial gas turbine components, characterised in that its weight composition is the following:
   Co:     0 to 5 %
   Cr:     13 to 16 %
   W:      0 to 2 %
   Mo:     2 to 3.5 %
   Al:     3.5 to 4 %
   Ti:     3.5 %
   Ta:     3.5 to 4 %
   Hf:     0 to 1 %
   C:      to 600 ppm
   Zr:     0 to 150 ppm
   B:      0 to 150 ppm
   Ni:     remainder to 100 %.

2. Superalloy according to Claim 1, characterised in that it is suitable for monocrystalline solidification and in that it is practically free from the following elements: Co, Hf, C, Zr and B.

3. Superalloy according to Claim 2, characterised in that its weight composition is the following:
   Cr:     16 %
   Mo:     3 %
   Al:     3.5 %
   Ti:     3.5 %
   Ta:     3.5 %
   Ni:     remainder to 100 %.

4. Superalloy according to Claim 2, characterised in that its weight composition is the following:
   Cr:     16 %
   W:      2 %
   Mo:     2 %
   Al:     3.5 %
   Ti:     3.5 %
   Ta:     3.5 %
   Ni:     remainder to 100 %.

5. Superalloy according to Claim 2, characterised in that its weight composition is the following:
   Cr:     13 %
   Mo:     3.5 %
   Al:     4 %
   Ti:     3.5 %
   Ta:     4 %
   Ni:     remainder to 100 %.

6. Superalloy according to Claim 1, characterised in that it is suitable for solidification in the form of columnar grains and in that its weight composition is the following:
   Co:     0 to 5 %
   Cr:     16 %
   Mo:     3 %
   Al:     3.5 %
   Ti:     3.5 %

Ta: 3.5 %
Hf: 1 %
C: 600 ppm
Zr: 150 ppm
B: 150 ppm
Ni: remainder to 100 %.

7. Superalloy according to Claim 6, characterised in that it is practically free from Co.

8. Superalloy according to Claim 6, characterised in that it contains approximately 5 % of Co.

9. Gas turbine blade made of a superalloy according to one of the preceding claims.

Nombre de cycles d'une heure

EP 0 382 585 B1

FIG.1

σ rupture en 1000 heures (MPa)

| | | IN 738 CC |
| | | DS-16-2 |
| | | SC-16 |
| | | SC-13-0 |
| | | DS 247 |

15    15    20

20    22    18

25    28

Température (°C)

800    850    900    950

FIG.2

EP 0 382 585 B1